# EUROPÄISCHE PATENTSCHRIFT

(11) **EP 0 862 796 B1**
(45) Veröffentlichungstag und Bekanntmachung des Hinweises auf die Patenterteilung: **12.02.2003**
(21) Anmeldenummer: 96940989.5
(22) Anmeldetag: 21.11.1996
(51) Int. Cl.: H01P 1/06

(54) **VORRICHTUNG ZUR SIGNALÜBERTRAGUNG ZWISCHEN BEWEGLICHEN TEILEN**
DEVICE FOR TRANSMITTING SIGNALS BETWEEN MOVING PARTS
DISPOSITIF POUR LA TRANSMISSION DE SIGNAUX ENTRE DES ELEMENTS MOBILES

(30) Priorität: 22.11.1995 DE 19543558; 22.11.1995 DE 19543559; 01.02.1996 DE 19610628
(43) Veröffentlichungstag der Anmeldung: 09.09.1998
(60) Teilanmeldung: 01102691.1
(73) Patentinhaber: Schleifring und Apparatebau GmbH, 82256 Fürstenfeldbruck (DE)
(72) Erfinder: LOHR, Georg, D-83071 Stephanskirchen (DE)
(74) Vertreter: Münich, Wilhelm, Dr.
(86) Internationale Anmeldenummer: DE9602222
(87) Internationale Veröffentlichungsnummer: WO97019483

(56) Entgegenhaltungen:
- EP-A- 0 179 413
- DE-A- 3 921 786
- GB-A- 1 112 402
- US-A- 2 401 572
- US-A- 3 013 225
- US-A- 4 613 973
- 1986 INTERNATIONAL CARNAHAN CONFERENCE ON SECURITY TECHNOLOGY-PROCEEDINGS, 12. - 14.August 1986, GOTHENBURG (SE), Seiten 245-249, XP002028065 M. SUZUKI ET AL.: "Experimental research on underground vehicle television monitoring system"
- IEEE TRANSACTIONS ON MICROWAVE THEORY AND TECHNIQUES, Bd. 30, Nr. 11, November 1982, NEW YORK US, Seiten 1874-1880, XP002028066 S.K. KOUL ET AL.: "Broadside, edge-coupled, symmetric strip transmission lines"
- JOURNAL OF PHYSICS E SCIENTIFIC INSTRUMENTS., Bd. 9, Nr. 4, April 1976, BRISTOL GB, Seiten 310-312, XP002032703 J. TER HORST ET AL.: "A variable delay circuit for use at high repetitive rates"
- IEEE JOURNAL OF SOLID-STATE CIRCUITS, Bd. 12, Nr. 3, Juni 1977, NEW YORK US, Seiten 276-280, XP002032704 W. FILENSKY ET AL.: "The GaAs MESFET as a pulse regenerator, amplifier, and laser modulator in the Gbit/s range"

## Beschreibung

### Technisches Gebiet

Die Erfindung bezieht sich auf Vorrichtungen zur Übertragung von hochfrequenten sowie digitalen Signalen zwischen bewegten Teilen, bestehend aus einer Signalquelle und einer Signalsenke verbunden durch einen Übertragungskanal.

### Stand der Technik

Hochfrequente wie auch digitale Signale müssen häufig zwischen relativ zueinander beweglichen Teilen übertragen werden. Ein typisches Einsatzgebiet solcher Übertragungsstrecken liegt in der Radartechnik, wo Signale von der Sende- und Empfangseinheit zur Antenne übertragen werden. Gegenstand der Erfindung ist hier nicht die Hochleistungs-Mikrowellen-Übertragung, sondern die Übertragung hochfrequenzter Signale wie z.B. Zwischenfrequenz-Signale oder auch digitale Daten. Derartige Signale werden in der Regel als unsymmetrische Signale zur Verfügung gestellt. Es sind verschiedene Vorrichtungen bekannt, um derartige unsymmetrische Signale zu übertragen.

So kann z.B. die Übertragung kapazitiv mittels eines Plattenpaketes ähnlich einem Drehkondensator erfolgen. Das Hauptproblem dieser Anordnung ist der nicht genau definierte Strompfad zwischen den zueinander beweglichen Teilen. So erfolgt ein Stromfluß zunächst über das Plattenpaket. Der rücklaufende Pfad ist in der Regel die Masse, meist als Schirm oder Gehäuse ausgeführt. Bei sich gegeneinander drehenden Teilen ist es aber besonders schwierig, eine gute, induktivitätsarme Masseverbindung herzustellen. Daher sind auch die bekannten Übertragungssysteme problembehaftet. Es ist hier sehr schwierig, konstante Übertragungseigenschaften und eine konstante Übersprechdämpfung zu erreichen.

Zwar zeichnen sich Übertragungsstrecken mittels Drehkondensatoren durch eine relativ hohe Bandbreite im Gegensatz zu anderen Übertragungstechniken aus, doch liegt der Nachteil im hohen technischen Aufwand der Plattenpakete und einer oberen Grenzfrequenz, die weit unter einer Wellenlänge liegt, die den Abmessungen des Plattenpaketes entspricht. Ein weiterer Nachteil dieser Anordnung ist die hohe Empfindlichkeit gegenüber mechanischen Beanspruchungen sowie Stoß und Vibration.

Auf verkoppelte Resonanzkreise basierende Übertragungsstrecken besitzen gute Übertragungseigenschaften, sind aber naturgemäß nur sehr schmalbandig. Sie sind auch gekennzeichnet durch einen hohen fertigungstechnischen Aufwand und benötigen gegebenenfalls einen Abgleich. Für unterschiedliche Anwendungsfälle müssen diese Elemente jeweils unterschiedlich dimensioniert werden, so daß es kaum möglich ist, mit solchen Übertragungsstrecken in Standardbauform eine breite Produktpalette zu realisieren.

Um die Nachteile dieser Anordnungen zu vermeiden wurden von mehreren Seiten Versuche Unternommen, die Hochfrequenzübertragungseigenschaften konventioneller Schleifringe zu verbessern. Ein solches Verfahren ist die gleichzeitige Einspeisung der Signale an mehreren Stellen, so daß in manchen Betriebszuständen Resonanzen erst bei höheren Frequenzen auftreten.

Ein anderes Verfahren versucht, einen Schleifring mit definiertem Wellenwiderstand auszubilden und diesen an einer geeigneten Stelle mit dem Wellenwiderstand abzuschließen.

Beide Verfahren sind für eine breitbandige Hochfrequenzübertragung gänzlich ungeeignet, da sie von einer geschlossenen, ringförmigen Kontaktbahn ausgehen. Diese wird immer eine kapazitive Last darstellen. Selbst bei Anbringung eines dem Wellenwiderstand entsprechenden Widerstandes kann ein geschlossener Ring niemals reflexionsfrei gestaltet werden. Warum dies nicht möglich ist, soll anhand von Fig. 4 und Fig. 5 erläutert werden.

Fig. 4 zeigt einen geschlossenen Ring 14, ausgebildet mit einem Wellenwiderstand von Z₀=50 Ω. An diesem ist ein reeller Widerstand 15 mit R=50 Ω angebracht. In Fig. 5 ist nun ein kleiner Ausschnitt des Ringes mit dem reellen Widerstand dargestellt. Unter der Prämisse, daß der Ring tatsächlich reflexionsfrei abgeschlossen ist, würde eine in Richtung 13 fortschreitende Welle vor dem Widerstand 15 eine Impedanz vorfinden, die sich aus einer Parallelschaltung von dem reellen Widerstand mit R=50 Ω sowie der hinter dem Widerstand weiterführenden Leitung mit Z₀=50 Ω ergibt. Der Wert der Parallelschaltung wäre damit 25 Ω. Damit kann für die Welle vor dem Widerstand die Leitung nicht reflexionsfrei sein. Auch mit allen anderen Kombinationen von Wellenwiderständen und Abschlußwiderständen läßt sich hier keine reflexionsfreie Leitung realisieren.

Die vorstehend beschriebenen kontaktlosen Übertragungsverfahren zeichnen sich gegenüber den kontaktierenden Verfahren durch vernachlässigbare mechanische Reibung und damit fehlenden Abrieb bzw. Kontaktverschleiß aus. Die Lebensdauer solcher kontaktloser Übertragungssysteme liegt insbesondere bei hohen Gechwindigkeiten der bewegten Teile zueinander wesentlich über der Lebensdauer kontaktierender Verfahren. Allen diesen Übertragungsverfahren haftet jedoch der Nachteil an, daß sie eine untere Grenzfrequenz besitzen. Diese kann je nach technischer Ausgestaltung variieren. Kennzeichnend ist jedoch, daß ein Gleichanteil mit der Frequenz 0 nicht direkt übertragen werden kann.

Die in der industriellen Praxis auftretenden Digitalsignale wie sie z. B. in modernen Bussystemen verwendet werden, variieren zwischen nahezu statischen Signalen mit äußerst niedrigen Frequenzen und Signalen mit einer durch das Bussystem vorgegebenen maximalen Taktrate. Die niedrigsten vorkommenden Frequenzen liegen meist unter der unateren Grenzfrequenz der zuvor beschriebenen kontaktlosen Überstragungssysteme.

Damit ist eine direkte Übertragung dieser Signale in der Regel nicht möglich. Abhilfe schaffen hier die bekannten Verfahren zur Modulation bzw. Kodierung. Beide Verfahren setzen einen hohen technischen Aufwand voraus. Insbesondere die für die Digitalsignalübertragung gut geeigneten Kodierungsverfahren, wie z. B. die Manchesterkodierung, benötigen alleine aufgrund der Kodierung eine höhere Bandbreite des Übertragungkanals. Dadurch steigen Aufwand und Kosten der Übertragungsstrecke. Außerdem wird bei den meisten Kodierungen der Takt des Digitalsignals benötigt. Häufig ist dieser Takt aus dem Signal selbst nicht rekonstruierbar. Nur wenn die Daten eine geeignete Struktur besitzen, ist mittels PLLs eine Taktregeneration möglich. Derartige Schaltungen sind meist für eine vorher festgelegte Datenrate einsetzbar. Soll die kontaktlose Übertragungsstrecke daten- und protokolltransparent sein, so lassen sich häufig nur die aufwendigen Modulationsverfahren einsetzen.

Aus der Patentschrift EP-Al-0179413 ist eine Anordnung zur Signalübertragung zwischen zueinander relativ beweglichen Teilen bekannt, die eine Signalquelle und eine Signalsenke aufweist, die durch einen Übertragungskanal verbunden sind, wobei im Signalpfad des Übertragungskanals eine symmetrische Koppeleinrichtung vorhanden ist, die das symmetrische Signal aus der Signalquelle zwischen den gegeneinander beweglichen Teilen überträgt. Diese Anordnung besitzt eine große Bandbreite. Auch aus den Druckschriften DE-A1-3921786 und US-A-2401572 sind derartige Anordnungen bekannt. Bei der Bildung des Oberbegriffs des Patentanspruchs 1 der vorliegenden Erfindung wurde von diesen genannten Druckschriften ausgegangen.

### Beschreibung der Erfindung

Gemäß dem Oberbegriff des Patentanspruchs 1 ist die Vorrichtung derart ausgebildet, dass die Übertragungsstrecke symmetrisch aufgebaut ist und dadurch ein genau definierter Strompfad vorhanden ist. Hin- und Rückweg des Stromes sind näherungsweise gleich ausgeführt. So muss der Signalstrom nicht über einen anderen, schlecht definierten Weg zurückfließen. Damit spielen schlechte Masseverbindungen keine Rolle mehr, es kann sogar auf eine Masseverbindung vollständig verzichtet werden. Damit kann gleichzeitig eine Potentialtrennung der relativ zueinander beweglichen Teile erreicht werden. Durch die symmetrische Übertragung ergibt sich weiterhin eine ausgezeichnete Gleichtaktunterdrückung. Dies ist gerade in jenen Fällen sehr von Vorteil, in denen eine schlechte oder keine Masseverbindung zwischen den beweglichen Teilen besteht, so dass erhebliche Spannungsdifferenzen zwischen diesen Teilen bestehen können.

Der Erfindung liegt die Aufgabe zugrunde, eine Vorrichtung zur Übertragung von Signalen zwischen beweglichen Teilen bestehend aus einer Signalquelle und einer Signalsenke verbunden durch einen Übertragungskanal derart weiterzubilden, dass eine zuverlässige, breitbandige Übertragung gewährleistet ist, ohne dass eine Masseverbindung zwischen den beweglichen Teilen benötigt wird. Insbesondere sollen Vorrichtungen angegeben werden, die für die Übertragung von Hochfrequenzsignalen und/oder von digitalen Signalen geeignet sind. Ferner soll zur Übertragung von digitalen Signalen eine protokoll- und datentransparente Übertragung mit einer Datenrate unter der unteren Grenzfrequenz der Übertragungsstrecke mit geringem technischen Aufwand und ohne vergrößertem Bandbreitenbedarf möglich sein.

Die Lösung der der Erfindung zugrundeliegenden Aufgabe ist im Patentanspruch 1 angegeben. Vorteilhafte Weiterbildungen der Erfindung sind Gegenstand der Unteransprüche.

Erfindungsgemäß wird die Aufgabe dadurch gelöst, dass die Koppeleinrichtung aus zwei Paaren gegeneinander angeordneter Leiterflächen bestehen. Die Leiterflächen sollen derart gestaltet sein, daß sie an den Weg der Bewegung angepaßt sind, und daß immer eine möglichst große Überlappung der Leiterflächen an den bewegten Teilen vorhanden ist, um eine möglichst große Verkopplung zu erhalten. Die einzelnen Leiterflächen eines jeden Paares sollen möglichst symmetrisch gestaltet sein, so dass die Symmetrie der gesamten Anordnung gewahrt bleibt.

In einer Ausgestaltung der erfindungsgemäßen Lösung sind die Anpassungsschaltungen mittels passiver Komponenten realisiert. So sind mehrere Schaltungen zur Impedanzanpassung und Symmetrierung mittels Leitungen und auch mit Übertragern bekannt. Selbstverständlich sind hier auch Realisierungen mit Hilfe anderer passiver Komponenten möglich.

Eine andere Ausgestaltung der Anordnung nach Anspruch 1 ist gekennzeichnet durch den Einsatz aktiver Komponenten in den Anpassungsschaltungen. Die Funktion dieser Anpassungsschaltungen lassen sich problemlos mittels Halbleiter und integrierten Verstärkern realisieren.

Weiterhin ist die erste Anpassungsschaltung mittels eines Verstärkers mit invertierendem und nicht invertierendem Ausgang realisierbar. Ebenso sind selbstverständlich auch zwei getrennte Verstärker einsetzbar. Die zweite Anpassungsschaltung läßt sich ebenso mittels eines Differenzverstärkers realisieren.

In einer weiteren Ausgestaltung der Anordnung nach Anspruch 1 zur Übertragung digitaler Informationen wird in der ersten Anpassungsschaltung ein Logikgatter mit invertierendem sowie nichtinvertierendem Ausgang eingesetzt. Ebenso sind auch hier zwei getrennte Logikgatter einsetzbar. Die zweite Anpassungsschaltung kann mit Hilfe eines Logikschaltkreises mit Differenzeingang realisiert werden.

In einer weiteren Ausgestaltung der erfindungsgemäßen Anordnung nach Anspruchs 1 werden die breitbandigen Signalübertragungseigenschaften einer reflexionsfrei abgeschlossenen Leitung genutzt. Eine solche Leitung kann entsprechend dem Stand der Technik als Koaxialleitung, Streifenleitung, oder auch symmetrische Zweidrahtleitung aufgebaut sein. Selbstverständlich sind auch andere Leitungstypen zur Führung elektromagnetischer Wellen geeignet, die über die Länge einen konstanten, definierten Wellenwiderstand besitzen und an mindestens einem Ende mit einem dem Wellenwiderstand entsprechenden Widerstand reflexionsfrei abgeschlossen sind. Wesentlicher Aspekt ist jedoch die Übertragung von TEM-Wellen in elektrischen Leitungen.

In der Regel sind derartige Leitungen an beiden Enden mit dem Wellenwiderstand abgeschlossen. Ebenso kann aber auch eine Signalquelle mit unangepasstem Innenwiderstand an eine Leitung, welche selbst mit einem dem Wellenwiderstand entsprechenden Widerstand reflexionsfrei abgeschlossen ist, angeschlossen werden. Am reflexionsfreien Abschluß kann keine Reflexion entstehen. Durch eine kreisförmige Anordnung einer solchen Leitung entsprechend dem Weg der Drehbewegung können die Informationen entlang der Leitung abgegriffen werden.

In der Darstellung der erfindungsgemäßen Anordnung nach Anspruch 5 wird auf den Begriff Leitung Bezug genommen. Selbstverständlich bezieht er sich auch im Falle mehrerer Leitungen auf alle Leitungen. Der Begriff Drehbewegung bezieht sich auf eine drehende Bewegung in einem beliebigen Winkelbereich und betrifft somit begrenzte Winkelbereiche bis hin zu kontinuierlichen Drehbewegungen.

In einer besonders vorteilhaften Ausführung erfolgt die Auskopplung von Signalen dieser Leitung über eine hochohmige Auskoppelschaltung, die somit am Ort der Auskopplung keine Reflexionen verursacht. Eine solche Auskoppelschaltung kann sich eines Übertragers oder auch eines Verstärkers mit hochohmigem Eingang oder eines Impedanzwandlers bedienen.

In einer weiteren vorteilhaften Ausgestaltung erfolgt die Auskopplung des Signals mittels einer Feldsonde. Dies kann sowohl eine E-Feldsonde als auch eine H-Feldsonde oder eine Kombination aus beiden Typen wie eine zweite verkoppelte Leitung sein. Wichtig bei der Gestaltung der Feldsonde ist, daß sie das Feld der Leitung nicht so beeinflußt, daß auf der Leitung Reflexionen entstehen. Eine Dämpfung des Signals auf der Leitung durch die Sonde ist zulässig, da hier keine weiteren Reflexionen auftreten.

In einer weiteren Ausgestaltung dieser erfindungsgemäßen Anordnung nach Anspruch 7 können auch kontaktierend Signale in die Leitung eingekoppelt werden. Hierzu ist es allerdings notwendig, die Leitung an beiden Enden reflexionsfrei abzuschließen, da sich vom drehbaren Punkt der Einkopplung aus Wellen in beiden Leitungsrichtungen fortpflanzen.

In einer anderen Ausgestaltung werden Signale über ein Koppelement in die Leitung eingekoppelt, welches eine Verkopplung der E-Felder und/oder der H-Felder herstellt. Dieses Koppelement kann im einfachsten Falle eine weitere Leitung sein, welche parallel zur ersten Leitung angeordnet ist.

### Kurze Beschreibung der Zeichnungen

Die Erfindung wird nachstehend anhand von Ausführungsbeispielen unter Bezugnahme auf die Zeichnung exemplarisch beschrieben. Es zeigen:
- Fig. 1: eine erfindungsgemäße Anordnung nach Anspruch 1,
- Fig. 2: eine praktische Realisierung der Koppeleinrichtung nach Anspruch 1,
- Fig. 3: Schematisierte Darstellung einer erfindungsgemäßen Anordnung nach Anspruch 5,
- Fig. 4: Übertragungseinrichtung gemäß dem Stand der Technik,
- Fig. 5: Ausschnitt aus Darstellung gemäß Figur 4,

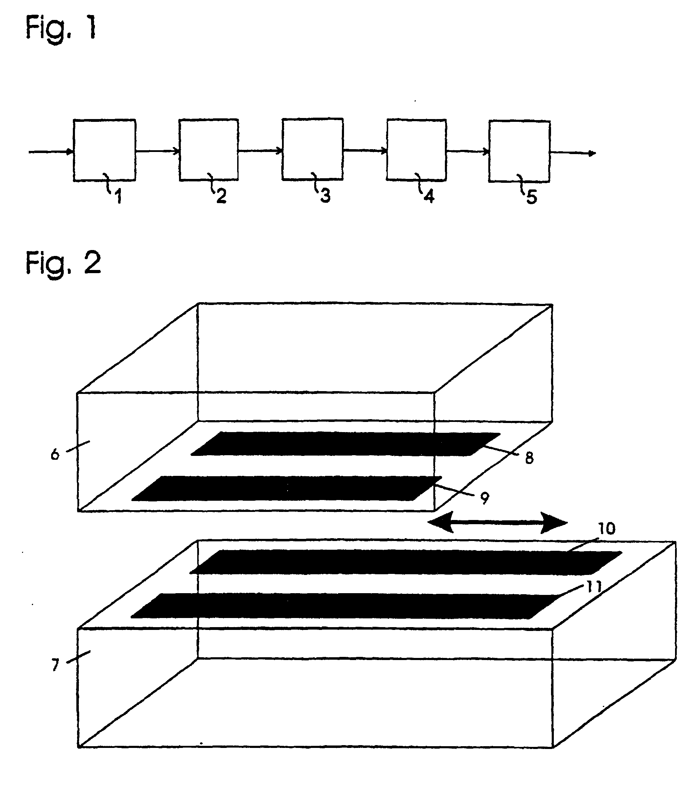

Fig. 1 zeigt eine Anordnung nach dem Anspruch 1, bestehend aus einer Signalquelle 1 sowie einer Signalsenke 5, verbunden durch die erste Anpassungsschaltung 2, die Koppeleinrichtung 3 und die zweite Anpassungsschaltung 4.

Fig. 2 zeigt eine praktische Realisierung der Koppeleinrichtung der Erfindung. Jeweils zwei näherungsweise gleich große Leiterflächen 8 und 9 bzw. 10 und 11 sind mittels Halteelemente 6 und 7 an den beiden gegeneinander beweglichen Teilen angeordnet. Der Pfeil gibt die Hauptbewegungsrichtung an. Bei Bewegungen in dieser Richtung bleibt die Übertragungsgüte konstant. Bei Bewegungen in alle anderen Richtungen variiert die Übertragungsgüte sehr stark.

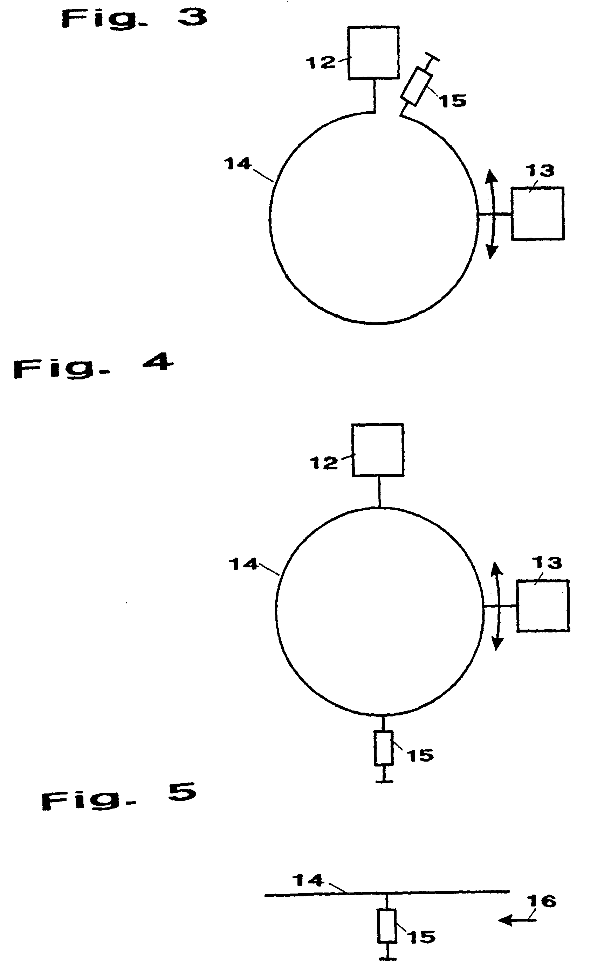

Figur 3 zeigt eine erfindungsgemäße Anordnung nach Anspruch 5. Eine Übertragungsstrecke zur Signalübermittlung bestehend aus einem Sender und/oder Empfänger 12 sowie einem relativ dazu rotierenden Empfänger und/oder Sender 13 welche mittels einer Leitung 14, die mit einer Impedanz 15 entsprechend ihrem Wellenwiderstand abgeschlossen ist, Signale austauschen.

Figur 4 stellt eine dem Stand der Technik entsprechende Anordnung dar. Sie besteht aus einem Sender und/oder Empfänger 12 verbunden mit einer zu einem Ring geschlossenen Leitung 14, die mit einem Abschlußwiderstand 15 verbunden ist. Die Signalübertragung zu dem relativ dazu rotierenden Empfänger und/oder Sender 13 erfolgt meistens durch galvanische Kontaktgabe mit der Leitung 14.

Figur 5 dient zur Erläuterung der Impedanzverhältnisse einer dem Stand der Technik entsprechenden Anordnung nach Fig. 4. Eine Elektromagnetische Welle, die sich in Richtung 16 ausbreitet findet unter der Annahme, der Leitungsring sei entsprechend seinem Wellenwiderstand abgeschlossen, eine Parallelschaltung der Impedanzen des Leitungsringes 14 und des Abschlußwiderstandes 15 vor. Der Gesamtwert der Impedanz ist in jedem Fall kleiner als die Impedanz des Leitungsringes und stellt damit eine Fehlanpassung dar.

## Patentansprüche

1. Anordnung zur Signalübertragung zwischen relativ zueinander beweglichen Teilen, bestehend aus einer Signalquelle und einer Signalsenke, die durch einen Übertragungskanal verbunden sind, wobei im Signalpfad des Übertragungskanals eine symmetrische Koppeleinrichtung vorhanden ist, die das symmetrische Signal aus der Signalquelle zwischen den gegeneinander beweglichen Teilen überträgt, wobei im Signalpfad des Übertragungskanals wahlweise eine erste Anpassungsschaltung vor dem Übertragungskanal angeordnet ist, die eine Umsetzung des Signals der Signalquelle in ein symmetrisches Signal vornimmt und weiterhin wahlweise eine zweite Anpassungsschaltung nach dem Übertragungskanal angeordnet ist, die das unsymmetrische Signal wieder in ein symmetrisches Signal zurückverwandelt
**dadurch gekennzeichnet, dass**
die symmetrische Koppeleinrichtung aus zwei näherungsweise gleich großen Leiterflächen zur Signalaussendung und in unmittelbarer Nähe zu diesen angeordnet aus zwei näherungsweise gleich großen Leiterflächen zum Signalempfang bestehen.

2. Anordnung nach Anspruch 1,
**dadurch gekennzeichnet, dass**
die Leiterflächen zur Signalaussendung andere oder gleiche Abmessungen als die Leiterflächen zum Signalempfang besitzen.

3. Anordnung nach einem der Ansprüche 1 bis 2,
**dadurch gekennzeichnet, dass**
die erste Anpassungsschaltung und/oder die zweite Anpassungschaltung wahlweise mit Hilfe von passiven Komponenten wie Übertragern und Leitungen oder mit Hilfe von aktiven Komponenten wie Halbleitern und Verstärkern realisiert sind.

4. Anordnung nach Anspruch 1 bis 3,
**dadurch gekennzeichnet, dass**
die erste Anpassungsschaltung wahlweise mit Hilfe eines Verstärkers und/oder Logikgatters mit invertierendem sowie nichtinvertierendem Ausgang realisiert ist und/oder die zweite Anpassungsschaltung wahlweise mit Hilfe eines Differenzverstärkers oder eines Logikschaltkreises mit Differenzeingang realisiert ist.

5. Anordnung zur Signalübertragung nach dem Oberbegriff des Anspruchs 1,
**dadurch gekennzeichnet, dass**
im Signalpfad des Übertragungskanals mindestens eine Leitung vorgesehen ist, die zumindest an einem Ende mit einem Widerstand entsprechend ihrem Wellenwiderstand reflexionsfrei abgeschlossen ist und den Empfänger speist und/oder wahlweise vom Sender gespeist wird.

6. Anordnung nach Anspruch 5,
**dadurch gekennzeichnet, dass**
im Signalpfad des Übertragungskanals die Auskopplung der Signale aus der Leitung über eine hochohmige Auskoppelschaltung und/oder über eine Feldsonde erfolgt, welche keine zusätzlichen Reflexionen auf der Leitung verursacht.

7. Anordnung nach Anspruch 5,
**dadurch gekennzeichnet, dass**
im Signalpfad des Übertragungskanals die Einkopplung der Signale in die Leitung kontaktierend erfolgt, und gleichzeitig die Leitung an beiden Enden entsprechend ihrem Wellenwiderstand reflexionsfrei abgeschlossen ist.

8. Anordnung nach Anspruch 6,
**dadurch gekennzeichnet, dass**
im Signalpfad des Übertragungskanals die Einkopplung der Signale in die Leitung über ein Koppelelement erfolgt, das über elektrische und/oder magnetische Felder Signale in die Leitung einkoppelt.

9. Anordnung nach einem der Ansprüche 1 bis 8,
**dadurch gekennzeichnet, dass**
die zu übertragenen Signale Hochfrequenzsignale sind.

## Claims

1. Arrangement for transmitting signals between parts mobile relative to each other, consisting of a signal source and a signal sink, which are connected by a transmission channel, with a symmetrical coupler means being provided in the signal path of the transmission channel, which means transmits the symmetrical signal from said signal source between said parts mobile relative to each other, wherein optionally a first matching circuit is disposed in the signal path ahead of said transmission channel, which realizes a conversion of the signal of the signal source into a symmetrical signal, and wherein furthermore optionally a second matching circuit is disposed behind said transmission channel, which converts the non-symmetrical signal back gain into a symmetrical signal,
**characterized in that**
said symmetrical coupler means consists of two conductor areas for signal transmission, having approximately the same size, and two conductor areas for signal reception, which have approximately the same size and are disposed in the immediate vicinity of the first conductor areas.

2. Arrangement according to Claim 1,
**characterized in that**
said conductor areas for signal transmission have dimensions different from or equal to the dimensions of said conductor areas for signal reception.

3. Arrangement according to any of the Claims 1 to 2,
**characterized in that**
said first matching circuit and/or said second matching circuit is/are realized optionally by means of passive components such as transformers and lines or by means of active components such as semiconductors and amplifiers.

4. Arrangement according to the Claims 1 to 3,
**characterized in that**
said first matching circuit is realized optionally by means of an amplifier and/or a logic gate circuit with an inverting output as well as a non-inverting output and/or said second matching circuit is realized optionally by means of a differential amplifier or a logic circuit with a differential input.

5. Arrangement for signal transmission according to the introductory clause Claim 1,
**characterized in that**
at least one line is provided in the signal path of said transmission channel, which is terminated in a reflection-free manner, at least on one end, with a resistance corresponding to its natural impedance, whilst it supplies said receiver and/or is optionally supplied by said transmitter.

6. Arrangement according to Claim 5,
**characterized in that**
in the signal path of said transmission channel, the signals are coupled out from said line via a highly resistant coupler circuit and/or via a field probe that does not cause additional reflections on the line.

7. Arrangement according to Claim 5,
**characterized in that**
in the signal path of said transmission channel, the signals are coupled into said line in a contacting manner whilst, at the same time, the line is terminated in a reflection-free manner on both ends in correspondence with its natural impedance.

8. Arrangement according to Claim 6,
**characterized in that**
in the signal path of said transmission channel, the signals are coupled into said line via a coupler element that couples signals into the line via electric and/or magnetic fields.

9. Arrangement according to any of the Claims 1 to 8,
**characterized in that**
the signals to be transmitted are high-frequency signals.

## Revendications

1. Arrangement pour la transmission de signaux entre des éléments mobiles l'un relativement à l'autre, composé d'une source de signaux et d'un puits de signaux, qui sont reliés par une voie de transmission, à un moyen de couplage symétrique étant disposé dans la voie de signaux de la voie de transmission, ce moyen faisant la transmission du signal symétrique à partir de ladite source de signaux entre lesdits éléments mobiles l'un relativement à l'autre, dans lequel, à volonté, un premier circuit d'adaptation est disposé dans la voie des signaux, en amont de ladite voie de transmission, qui réalise une conversion du signal de la source de signaux en un signal symétrique, et dans lequel de plus, à volonté, un deuxième circuit d'adaptation est disposé en aval de ladite voie de transmission, qui sert à reconvertir le signal non symétrique encore en un signal symétrique,
**caractérisé en ce que**
ledit moyen de couplage symétrique est composé de deux aires conductrices pour la transmission de signaux, aux mêmes dimensions environ, et par deux aires conductrices pour la réception de signaux, aux mêmes dimensions environ, qui sont disposées au voisinage immédiat desdites premières aires conductrices.

2. Arrangement selon la revendication 1,
**caractérisé en ce que**
lesdites aires conductrices pour la transmission de signaux ont des dimensions différentes de ou égales aux dimensions desdites aires conductrices pour la réception de signaux.

3. Arrangement selon la revendication 1 to 2,
**caractérisé en ce que**
ledit premier circuit d'adaptation et/ou ledit deuxième circuit d'adaptation est/sont réalisé(s), à volonté, moyennant des composants passifs, comme des transformateurs et lignes, ou moyennant des composants actifs, comme les semi-conducteurs et amplificateurs.

4. Arrangement selon les revendications 1 à 3,
**caractérisé en ce que**
ledit premier circuit d'adaptation est réalisé, jà volonté, moyennant un amplificateur et/ou une porte de circuit logique à une sortie inverseur ainsi qu'une sortie non inverseur, et/ou **en ce que** ledit deuxième circuit d'adaptation est réalisé, à volonté, moyennant un amplificateur différentiel ou un circuit logique à une entrée différentielle.

5. Arrangement pour la transmission de signaux selon le préambule de la revendication 1,
**caractérisé en ce**
**qu'**au moins une ligne est montée dans la voie des signaux de ladite voie de transmission, qui est terminée sans réflexions, au moins à une extrémité, à une résistance correspondante à son impédance caractéristique, pendant qu'elle alimente ledit récepteur et/ou est alimentée, à volonté, par ledit émetteur.

6. Arrangement selon la revendication 5,
**caractérisé en ce que**
dans la voie des signaux de ladite voie de transmission, les signaux sont couplés en dehors de ladite ligne via un circuit coupleur à haute résistance et/ou via une sonde de champ, qui ne donne lieu aux réflexions additionnelles sur la ligne.

7. Arrangement selon la revendication 5,
**caractérisé en ce que**
dans la voie des signaux de ladite voie de transmission, les signaux sont couplés dans ladite ligne par contact, pendant que la ligne est terminée, au même temps, sans réflexions aux deux extrémités en correspondance avec son impédance caractéristique.

8. Arrangement selon la revendication 6,
**caractérisé en ce que**
dans la voie des signaux de ladite voie de transmission, les signaux sont couplés dans ladite ligne via un élément coupleur, qui couple des signaux dans la ligne via des champs électriques et/ou magnétiques.

9. Arrangement selon la revendication 1 to 8,
**caractérisé en ce que**
les signaux à transmettre sont des signaux à haute fréquence.
